# EUROPÄISCHE PATENTANMELDUNG

(11) **EP 2 172 971 A2**
(43) Veröffentlichungstag der Anmeldung: **07.04.2010**
(21) Anmeldenummer: 09169318.4
(22) Anmeldetag: 03.09.2009
(51) Int. Cl.: H01L 23/40

(54) **Kühlanordnung**

(30) Priorität: 01.10.2008 AT 15282008
(71) Anmelder: Siemens AG Österreich, 1210 Wien (AT)
(72) Erfinder: Petricek, Martin, 2020, Hollabrunn (AT)
(74) Vertreter: Maier, Daniel Oliver

(57) **Zusammenfassung**

Die Erfindung betrifft eine Kühlanordnung mit wenigstens zwei zu kühlenden elektronischen Bauteilen (3), welche mittels einer Spannvorrichtung gegen einen Kühlkörper (2) gedrückt sind, wobei die Spannvorrichtung eine gewellt ausgeführte Blattfeder (1) umfasst, welche vorgespannt zwischen den zu kühlenden elektronischen Bauteilen (3) und einer Gegenhalterung (4) angeordnet ist. Auf diese Weise sind mehrere zu kühlende Bauteile (3) mit nur einer Spannvorrichtung gegen einen Kühlkörper (2) spannbar.

## Beschreibung

Die Erfindung betrifft eine Kühlanordnung mit wenigstens zwei zu kühlenden elektronischen Bauteilen, welche mittels einer Spannvorrichtung gegen einen Kühlkörper gedrückt sind.

Viele elektronische Bauteile wie beispielsweise Transistoren erzeugen im Betrieb Wärme, die abgeführt werden muss, damit das Bauteil nicht überhitzt und infolgedessen ausfällt. Zu kühlende Bauteile umfassen dabei in der Regel eine ebene Kühlfläche, welche gegen einen Kühlkörper gedrückt ist. Die Andrückkraft hat dabei einen großen Einfluss auf den Wärmeübergang zwischen dem Bauteil und dem Kühlkörper.

Nach dem Stand der Technik kommen verschiedenste Spannvorrichtungen wie beispielsweise elastische Metallklammern zum Einsatz, welche das Bauteil und den Kühlkörper umklammern. Oft weisen zu kühlende Bauteile auch Bohrungen zur Durchführung von Spannelementen auf.

Bei mehreren zu kühlenden Bauteilen ist in der Regel ein gemeinsamer Kühlkörper angeordnet. Insbesondere bei Bauteilen unterschiedlicher Größe ist dabei jeder Bauteil mit einer eigenen Spannvorrichtung gegen den Kühlkörper gespannt. Das macht für jeden zu montierenden Bauteil einen eigenen Arbeitsschritt erforderlich.

Der Erfindung liegt die Aufgabe zugrunde, für eine Kühlanordnung der eingangs genannten Art eine Verbesserung gegenüber dem Stand der Technik anzugeben.

Erfindungsgemäß wird diese Aufgabe gelöst durch die Merkmale des Anspruchs 1. Dabei umfasst die Spannvorrichtung eine gewellt ausgeführte Blattfeder, welche vorgespannt zwischen den zu kühlenden elektronischen Bauteilen und einer Gegenhalterung angeordnet ist. Auf diese Weise sind mehrere zu kühlende Bauteile mit nur einer Spannvorrichtung gegen einen Kühlkörper spannbar. Die gewellte Blattfeder gleicht dabei unterschiedliche Abmaße einzelnen Bauteile aus, wobei sich für jeden Bauteil eine annähernd gleich große Andrückkraft einstellt.

Vorteilhafterweise liegt auf einer dem Kühlkörper abgewandten Seite eines jeden zu kühlenden Bauteils jeweils ein Wellenberg der Blattfeder auf. Zwischen der Blattfeder und jedem einzelnen Bauteilen ist dann nur eine Kontaktstelle zur Übertragung der Andrückkraft ausgebildet, sodass keine Kippmomente auftreten können.

Bei einfachen Anwendungen ist es von Vorteil, wenn die Blattfeder gleichmäßig gewellt ausgeführt ist. Solche Blattfedern sind als vorgefertigte Teile kostengünstig herstellbar.

Es kann bei komplexeren Layouts auch von Vorteil sein, eine gewellt ausgeführte Blattfeder mit unterschiedlichen Wellenperioden anzuordnen. Solche Blattfedern sind in Anordnungen mit stark voneinander abweichenden Abständen zwischen mehreren zu kühlenden Bauteilen einsetzbar.

Dabei ist es in jedem Fall günstig, wenn die Wellenperioden der Blattfeder in der Weise festgelegt sind, dass jeweils ein Wellenberg mittig auf einer dem Kühlkörper abgewandten Seite eines jeden zu kühlenden Bauteils aufliegt. Auf diese Weise ist eine gleichmäßige Druckverteilung auf der dem Kühlkörper zugewandten Kühlfläche der einzelnen Bauteile sichergestellt.

Bei stark voneinander abweichenden Dicken der einzelnen zu kühlenden Bauteile weist die gewellt ausgeführte Blattfeder vorteilhafterweise unterschiedlich hohe Wellenberge auf. Das ist auch dann sinnvoll, wenn für die einzelnen Bauteile unterschiedlich starke Andrückkräfte vorzusehen sind.

In einer vorteilhaften Ausführung der Erfindung ist des Weiteren vorgesehen, dass die Gegenhalterung im Wesentlichen stabförmig ausgeführt ist und an ihren Enden mit Befestigungsmitteln gegen den Kühlkörper gespannt ist. Die stabförmige Gegenhalterung wird dabei auf Biegung beansprucht und weist eine entsprechende Steifigkeit auf, sodass die Andrückkraft im Wesentlichen aus der Vorspannung der gewellt ausgeführten Blattfeder resultiert.

Die Befestigungsmittel zur Verbindung der Gegenhalterung mit dem Kühlkörper sind günstigerweise als Schraubverbindungen ausgeführt, wobei die Andrückkraft kontinuierlich verstellt werden kann. Für einfache Anwendungen sind als Befestigungsmittel auch Klippverbindungen oder Pressverbindungen einsetzbar.

Die Steifigkeit bzw. ein hohes Widerstandsmoment der Gegenhalterung wird günstigerweise durch einen U-förmigen Querschnitt erreicht, wobei der Abstand zwischen den Querschnittschenkeln größer ist als die Breite der gewellt ausgeführten Blattfeder. Die Blattfeder ist dann in einfacher Weise zwischen den Querschnittschenkeln der Gegenhalterung positionierbar.

Zur Vereinfachung der Montage ist es schließlich günstig, wenn die Blattfeder und die Gegenhalterung miteinander verbunden sind. Die Position der Blattfeder ist dann eindeutig bestimmt.

Die Erfindung wird nachfolgend in beispielhafter Weise unter Bezugnahme auf die beigefügten Figuren erläutert. Es zeigen in schematischer Darstellung:
- Fig. 1: Explosionsdarstellung der Kühlanordnung in Schrägansicht
- Fig. 2: Gegenhalterung mit gewellt ausgeführter Blattfeder
- Fig. 3: Montierte Kühlanordnung in Schrägansicht
- Fig. 4: Aufsicht der montierten Kühlanordnung

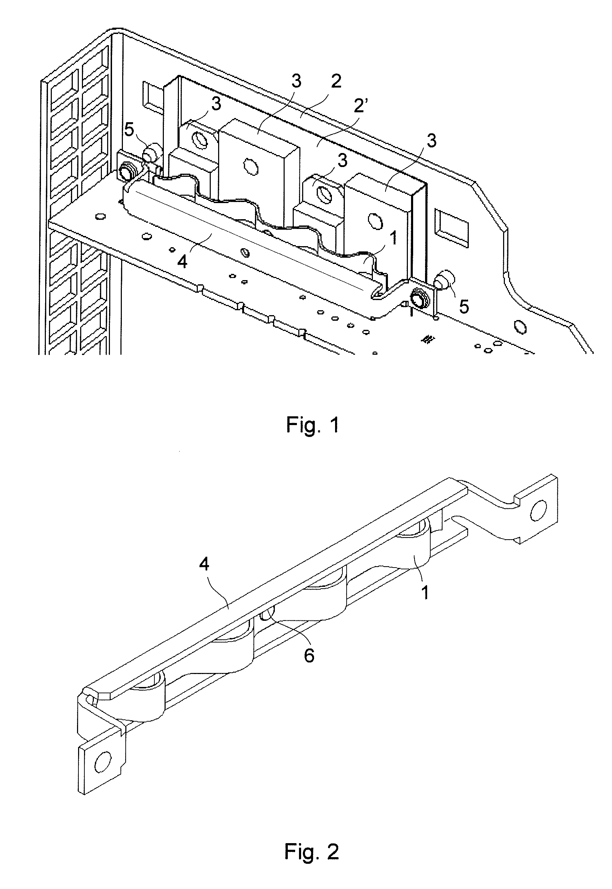

Die in Fig. 1 dargestellte beispielhafte Anordnung umfasst vier zu kühlende elektronische Bauteile 3, welche nebeneinander gegen einen Kühlkörper 2 gedrückt sind. Zwischen dem Kühlkörper 2 und den Bauteilen 3 ist eine Wärme leitende Isolierschicht 2' angeordnet. Über Befestigungsmittel 5 sind die beiden Enden einer stabförmigen Gegenhalterung 4 mit dem Kühlkörper 2 verbunden. Dabei sind am Kühlkörper 2 zwei zapfenförmige Fortsätze angebracht, die im montierten Zustand durch entsprechende Löcher der Gegenhalterung geführt sind und mit diesen eine Presspassung bilden. Alternativ dazu können Schraubverbindungen oder Klippverbindungen zur Anwendung kommen.

Die Enden der Gegenhalterung 4 sind in Richtung des Kühlkörpers 2 abgewinkelt und bestimmen auf diese Weise die Distanz zwischen dem geraden Mittelteil der Gegenhalterung 4 und dem Kühlkörper 2. Diese Distanz ist so gewählt, dass eine zwischen den Bauteilen und der Gegenhalterung 4 angeordneten gewellt ausgeführten Blattfeder 1 im montierten Zustand vorgespannt ist. Die Vorspannung der Blattfeder 1 bestimmt dabei die Andrückkraft, mit der die einzelnen Bauteile 3 gegen den Kühlkörper gedrückt sind.

In der beispielhaften Anordnung weisen die zu kühlenden Bauteile 3 annähernd gleiche Abstände auf. Die Blattfeder 1 ist deshalb gleichmäßig gewellt mit gleichbleibenden Wellenperioden. Jedem zu kühlenden Bauteil 3 ist ein Wellenberg zugeordnet, wobei zu beachten ist, dass auf der der Gegenhalterung 4 zugewandten Seite ein Wellenberg mehr vorzusehen ist. Dabei sind die Enden der Blattfeder 1, welche sich gegen die Gegenhalterung 4 abstützen, auch als Wellenberge bezeichnet. Auf diese Weise ist sichergestellt, dass auch die Wellenberge, die gegen die äußeren Bauteile 3 drücken, beidseitig gegen die Gegenhalterung 4 abgestützt sind.

In Fig. 2 ist die Gegenhalterung 4 mit U-förmigem Querschnitt des geraden Mittelteils dargestellt. Die Querschnittschenkel weisen dabei in dieselbe Richtung wie die abgewinkelten Enden, sodass eine Wanne entsteht, in welche die Blattfeder 1 eingelegt ist. Die Wellenberge, die im montierten Zustand mit den Bauteilen 3 kontaktiert sind, ragen dabei über die Querschnittschenkel hinaus, sodass ein ausreichender Federweg zur Erzielung einer Vorspannung gegeben ist. Zur Fixierung der Blattfeder 1 während der Montage ist eine Verbindung zwischen der Blattfeder 1 und der Gegenhalterung 4 vorgesehen. Dabei kann es sich beispielsweise um eine Nietverbindung 6 handeln.

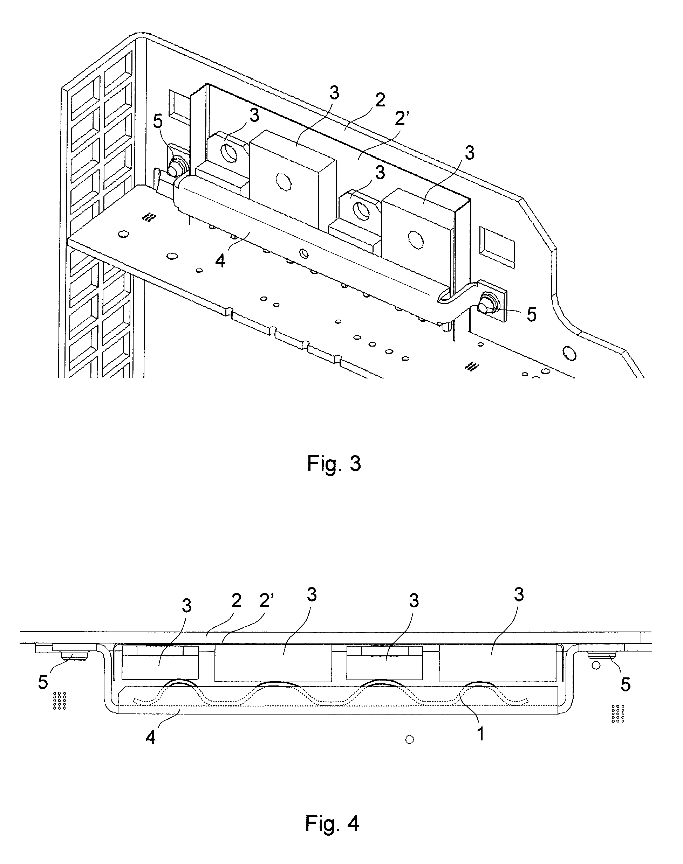

Fig. 3 zeigt die in Fig. 1 dargestellte Anordnung im montierten Zustand. Dieselbe Anordnung ist in Fig. 4 in einer Aufsicht dargestellt. Die vier zu kühlenden Bauteile 3 liegen mit ihren Kühlflächen auf der Wärme leitenden Isolierschicht 2' auf, welche zwischen den Bauteilen 3 und dem Kühlkörper 2 angeordnet ist. Die gegenüber den Kühlflächen liegenden Flächen der Bauteile 4 dienen als Kontaktflächen für die Blattfeder 1, wobei diese Kontaktflächen nicht in einer Ebene liegen müssen. Versetzte Kontaktflächen werden durch die Biegungen der Blattfeder 1 ausgeglichen.

Die Gegenhalterung 4 ist mit ihren zweifach abgewinkelten Enden an dem Kühlkörper 2 befestigt. Die Länge dieser Distanz bildenden Enden der Gegenhalterung 4 ist mit der Höhe der Wellenberge der gewellten Blattfeder 1 und den Dicken der einzelnen Bauteile 3 so abgestimmt, dass die Blattfeder 1 im montierten Zustand die gewünschte Vorspannung aufweist. Als Dicke eines Bauteils 3 wird dabei der Abstand zwischen der Kühlfläche und der gegenüberliegenden Kontaktfläche bezeichnet.

Es sind auch Blattfedern 1 mit - im entspannten Zustand - unterschiedlich hohen Wellenbergen einsetzbar, falls die einzelnen Bauteile 3 stark voneinander abweichende Dicken aufweisen oder wenn die Art der Bauteile 3 stark voneinander abweichende Andrückkräfte erfordert.

## Patentansprüche

1. Kühlanordnung mit wenigstens zwei zu kühlenden elektronischen Bauteilen (3), welche mittels einer Spannvorrichtung gegen einen Kühlkörper (2) gedrückt sind, **dadurch gekennzeichnet, dass** die Spannvorrichtung eine gewellt ausgeführte Blattfeder (1) umfasst, welche vorgespannt zwischen den zu kühlenden elektronischen Bauteilen (3) und einer Gegenhalterung (4) angeordnet ist.

2. Kühlanordnung nach Anspruch 1, **dadurch gekennzeichnet, dass** auf einer dem Kühlkörper (2) abgewandten Seite eines jeden zu kühlenden Bauteils (3) jeweils ein Wellenberg der Blattfeder (1) aufliegt.

3. Kühlanordnung nach Anspruch 1 oder 2, **dadurch gekennzeichnet, dass** die Blattfeder (1) gleichmäßig gewellt ausgeführt ist.

4. Kühlanordnung nach Anspruch 1 oder 2, **dadurch gekennzeichnet, dass** die gewellt ausgeführte Blattfeder (1) unterschiedliche Wellenperioden aufweist.

5. Kühlanordnung nach einem der Ansprüche 1 bis 4, **dadurch gekennzeichnet, dass** die Wellenperioden der Blattfeder (1) in der Weise festgelegt sind, dass jeweils ein Wellenberg mittig auf einer dem Kühlkörper abgewandten Seite eines jeden zu kühlenden Bauteils (3) aufliegt.

6. Kühlanordnung nach einem der Ansprüche 1 bis 5, **dadurch gekennzeichnet, dass** die gewellt ausgeführte Blattfeder (1) unterschiedlich hohe Wellenberge aufweist.

7. Kühlanordnung nach einem der Ansprüche 1 bis 6, **dadurch gekennzeichnet, dass** die Gegenhalterung (4) im Wesentlichen stabförmig ausgeführt ist und an ihren Enden mit Befestigungsmitteln (5) gegen den Kühlkörper (2) gespannt ist.

8. Kühlanordnung nach Anspruch 7, **dadurch gekennzeichnet, dass** die Befestigungsmittel (5) als Schraubverbindung, als Kippverbindung oder als Pressverbindung ausgeführt sind.

9. Kühlanordnung nach einem der Ansprüche 1 bis 8, **dadurch gekennzeichnet, dass** die Gegenhalterung (4) einen U-förmigen Querschnitt aufweist und der Abstand zwischen den Querschnittschenkel größer ist als die Breite der gewellt ausgeführten Blattfeder (1).

10. Kühlanordnung nach einem der Ansprüche 1 bis 9, **dadurch gekennzeichnet, dass** die Blattfeder (1) und die Gegenhalterung (4) miteinander verbunden sind.
